# EUROPEAN PATENT APPLICATION

(11) **EP 1 715 529 A2**
(43) Date of publication of application: **25.10.2006**
(21) Application number: 06004722.2
(22) Date of filing: 08.03.2006
(51) Int. Cl.: H01L 31/0224

(54) **Solar cell with feedthrough via**

(30) Priority: 19.04.2005 US 109016
(71) Applicant: Emcore Corporation, Albuquerque NM 87123 (US)
(72) Inventor: Sharps, Paul R., Albuquerque NM 87112 (US); Aiken, Daniel J., Ceder Crest NM 87008 (US); Clevenger, Marvin Bradford, Albuquerque NM 87111 (US)
(74) Representative: Wagner, Karl H.

(57) **Abstract**

A semiconductor structure that includes a first semiconductor region forming a first surface of the semiconductor structure and having a first polarity and a second semiconductor region forming a second surface of the semiconductor structure and having a second polarity. The structure further includes at least one insulated via formed in the semiconductor structure from said first surface to said second surface, an electrical connection extending through said via and an insulated contact pad on the first surface of the semiconductor structure, said electrical connection extending from said second semiconductor region to said insulated contact pad so as to form a terminal of said second semiconductor region on the first surface.

## Description

### Field of the Invention

The field of the invention relates to solar cells and more particularly to methods of connecting solar cells to external devices.

### Background of the Invention

Solar cells (photovoltaic cells) are designed to convert impinging light into electrical energy and are generally known. Such conversion occurs without the use of either chemical reaction or moving parts.

Solar cells are typically constructed on silicon (Si) substrates with a photoactive semiconductor disposed on a light-absorbing side of the substrate. The photoactive semiconductor layer may include one or more p-n junctions.

Two other contact layers may also be necessary for purposes of making electrical contact. One electrical contact layer is typically placed on a light absorbing side of the solar cell and a second layer is placed on a back of the cell.

The contact layer on the face of the cell where light enters is generally present in the form of a grid pattern and is generally composed of a good conductor such as metal. The grid pattern does not cover the entire face of the cell since grid materials, though good electrical conductors, are generally not transparent to light.

The grid pattern on the face of the cell is generally widely spaced to allow light to enter the solar cell but not to the extent that the electrical contact layer will have difficulty collecting the current produced by the cell. The back electrical contact layer has no such diametrically opposing restrictions. The back layer simply functions as an electrical contact and thus covers the entire back surface of the cell structure. Because the back layer must be a very good electrical conductor, it is always made of metal.

While solar cells are effective, their efficiency is limited, due, in part, to the contact grid on the face of the solar cell. Because of the limited efficiency of solar cells, a need exists for a method of reducing the light blocking effect of the contact grid on the face of solar cells.

### Summary

A semiconductor structure that includes a first semiconductor region forming a first surface of the semiconductor structure and having a first polarity and a second semiconductor region forming a second surface of the semiconductor structure and having a second polarity. The structure further includes at least one insulating via formed in the semiconductor structure from said first surface to said second surface, an electrical connection extending through said via and an insulated contact pad on the first surface of the semiconductor structure, said electrical connection extending from said second semiconductor region to said insulated contact pad so as to form a terminal of said second semiconductor region on the first surface.

### Brief Description of the Drawings

FIG. 1 shows a solar cell array under an illustrated embodiment of the invention;
FIG. 2 shows a cut-away view of a solar cell of the array of FIG. 1; and
FIG. 3 shows a bottom view of the solar cell array of FIG. 1.

### Detailed Description of an Illustrated Embodiment

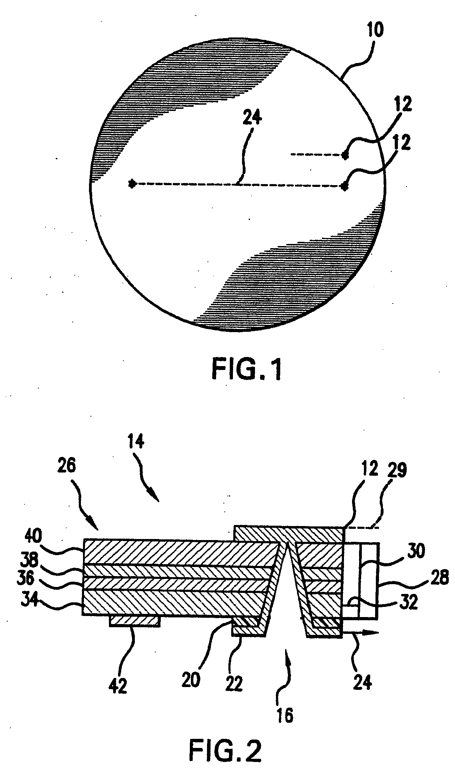

FIG. 1 is a top view of an array of solar cells (e.g., a wafer) 10 shown generally in accordance with an illustrated embodiment of the invention. FIG. 2 is a cut-away side view of a single solar cell 14 of the wafer 10 of FIG. 1.

The present invention relates to the fabrication of multijunction solar cells using group III-V elements. Solar cell semiconductor devices, such as those depicted in U.S. Pat. No. 6,680,432 may often include integral bypass diodes epitaxially grown on the substrate but separated from the solar cell structure by a trench that provides electrical isolation of the solar cell and the bypass diode.

The bypass diode may be provided to reduce the deleterious effects of reverse biasing caused by partial light shading of individual solar cells 14 of the array 10. Although the present invention may be implemented in any solar cell device, the description that follows will make reference to an implementation that includes the integral bypass diodes as an illustration of an advanced device.

FIG. 2 illustrates a simplified sectional view of an integral semiconductor structure of the solar cell 14 with a triple junction solar cell structure 26 and a monolithic or integral bypass diode 28. The device 14 includes a substrate 34, the triple junction solar cell 26, a well 30 and a shunt 32. The triple junction cell structure 26 may further include a bottom, middle and top subcells 36, 38, 40, respectively.

In one embodiment, the substrate is a p-type germanium ("Ge") substrate 34, which has a lower metal contact pad 42. The bottom subcell 36 may contain a p-type Ge base layer, an n-type Ge emitter layer and an n-type GaAs layer. The base layer may be deposited over the substrate 34. The emitter layer may be deposited over the base layer, which in one embodiment can be formed through diffusion from the emitter layer. After the bottom subcell 36 is deposited, p-type and n-type tunneling junction layers (forming a tunneling diode) may also be deposited.

The middle layer 38 may include a back surface field ("BSF") layer, a p-type GaAs base layer, an n-type GaAs emitter layer and an n-type gallium indium phosphide2 (GaInP2) window layer. The BSF layer drives minority carriers from a highly doped region near the back surface to minimize the effect of recombination loss. In other words, the BSF layer reduces recombination loss at the backside of the solar cell and thereby reduces the recombination in the bare region.

The window layer used of the middle subscell 38 also operates to reduce the recombination loss. The window layer also improves the passivation of the subcell surface of the underlying junctions. Before depositing the layers of the top subscell 40, p-type and n-type tunneling junction layers may be deposited over the middle subcell 38.

The top subcell 40 may include p-type indium gallium aluminum phosphide2 ("InGaAlP2") BSF layer, a p-type GaInP2 base layer, an n-type GaInP2 emitter layer and an n-type aluminum indium phosphide2 ("AlInP2") window layer. The base layer may be deposited on the BSF layer once the BSF layer is deposited over the tunneling junction layers of the middle subcell 38. The window layer is subsequently deposited on the emitter layer after the emitter layer is deposited on the base layer.

As in prior art devices, an n-type cap layer may be employed for enhancing contact with metal materials. The cap layer may be deposited over the top subcell 40.

In embodiments in which a bypass diode is formed, the cap layer also acts as a lateral conduction layer for the bypass diode. An n-type GaInP2 stop etch layer may be deposited over the lateral conduction layer. After the stop etch layer is deposited, the bypass diode may be epitaxially deposited.

In the embodiment in which a bypass diode is formed, the bypass diode 28 may include an n-type GaAs layer, an i-type GaAs layer and a p-type GaAs layer. The n-type layer is deposited over the stop etch layer. The i-type layer may be deposited over the n-type layer. The p-type layer is deposited over the i-type layer. After the p-type GaAs layer is deposited, a contact pad 29 may be deposited over the bypass diode 28.

In one embodiment, a metal shunt 32 may be deposited into a portion of the well 30. One side of the shunt 32 makes chemical contact with substrate 34 and another side of the shunt 32 makes electrical contact with the lateral conduction layer on a top of the cell 14 and thereby to a portion of the triple junction cell 26. An anti-reflection coating may be deposited over certain parts of the cell 14 to enhance its performance.

It should be noted that the multijunction cell solar cell 14 could be formed by any combination of group III to V elements listed in the periodic table, wherein the group III elements include boron (B), aluminum (A1), gallium (Ga), indium (In), and thallium (T). The group IV elements include carbon (C), silicon (Si), germanium (Ge), and tin (Sn). The group V elements includes nitrogen (N), phosphorus (P), arsenic (As), antimony (Sb), and bismuth (Bi).

Under illustrated embodiments of the wafer 10, the prior art grid structure that would otherwise be used on the light collecting surface is replaced with a relatively small collector element 12 disposed on a light gathering face of the cell 14. A via 16 connects the collector element 12 to a current gathering grid disposed on a lower side of the wafer 10.

The via 16 may be created by creating a small hole in the wafer 10 by any appropriate method (e.g., laser ablation) and disposing an insulating material (e.g., Si02) 20 around the hole. The inside of the hole and outer surface of the insulating layer 20 may be plated with an appropriate conductive material (e.g., metal).

In the case where the diode 28 is used, the insulating material around the hole may be present on both the top and bottom sides of the cell 14. The insulating material on the top side may isolate the contact 12 from the upper subcell 40. Appropriate contact may then be made with the diode 28 via an extension 29 of the contact 12.

Where a diode 28 is not used, then the insulating material 20 around the hole may be present only on the bottom side of the cell 14 to isolate the potential of the top contact 12 from the potential of the substrate 34 and lower contact 42. In this case, a contact 22 may be formed on top of the insulating material 20.

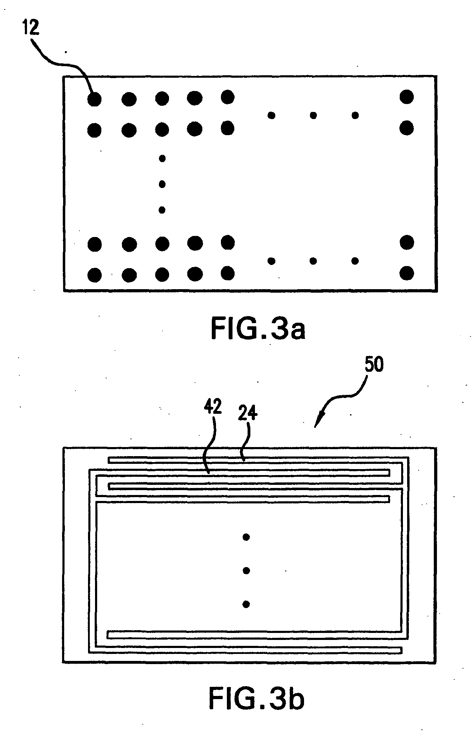

The vias 16 allows the collector elements 12 to be connected with other solar cells 14 using a set of interconnect traces 24 disposed on the bottom of the solar cell 14, instead of the top, as shown in FIG. 3. Placing the interconnection on the bottom of the wafer 10 eliminates the necessity for connecting traces on the face of the wafer 10 thereby reducing the shadowing of the cells 14 produced by the interconnecting traces.

It should be noted in this regard, that as more and more cells 14 of the wafer 10 are connected together (or the sizes of the cells 14 are increased), the traces 24 must be increased in size to accommodate the larger current. However, any increase in the size of any trace on the upper surface of the wafer 10 (as under the prior art) would result in less light reaching the cells 14.

FIG. 1 shows the collecting elements 12 on the wafer 10. The collecting elements 12 may be of any appropriate shape that minimizes shading. In one illustrated embodiment, the contact 12 may include a circular central region with a number of radiating spikes (e.g., in the form of an asterisk).

While FIG. 2 shows the contact 12 and via 16 disposed in the photoactive area of the solar cell 14, it should also be recognized that the via 16 may be moved to a location that is laterally adjacent the diode 28 along a periphery of the cell 14. This would allow the contact 12 to be placed substantially over the diode 28. The spikes that radiate from the contact 12 may then extend into the photoactive area on both sides of the diode 28 in a manner that meets or exceeds the current collection capability of prior art top surface grids while improving the overall percentage of light reaching the photoactive area of the cell 14.

FIG. 3a and 3b show top and bottom surfaces of a cell 14 that further illustrates embodiments of the invention. As shown in FIG. 3a, the number of collecting elements 12 per unit area can be increased to any level (as indicated by the ellipsis in FIG. 3a) that maximizes efficiency, yet reduces shading.

FIG. 3b depicts a bottom surface of the cell 14 of FIG. 3a. As shown in FIG. 3b, a grid 50 of interdigited traces 24, 42 may be disposed in an alternating manner across the bottom of the cell 14. As indicated by the ellipsis in FIG. 3b, the number and density of traces 24, 42 are only limited by the desire of the designer to maximize the density of the collecting elements 12 on the light collecting surface.

A specific embodiment of method and apparatus for collecting current from solar cells has been described for the purpose of illustrating the manner in which the invention is made and used. It should be understood that the implementation of other variations and modifications of the invention and its various aspects will be apparent to one skilled in the art, and that the invention is not limited by the specific embodiments described. Therefore, it is contemplated to cover the present invention and any and all modifications, variations, or equivalents that fall within the true spirit and scope of the basic underlying principles disclosed and claimed herein.

## Claims

1. A semiconductor structure comprising:
a first semiconductor region forming a first surface of the semiconductor structure and having a first polarity;
a second semiconductor region forming a second surface of the semiconductor structure and having a second polarity;
at least one via formed in the semiconductor structure from said first surface to said second surface;
an electrical connection extending through said via; and
an insulated contact pad on the first surface of the semiconductor structure, said electrical connection extending from said second semiconductor region to said insulated contact pad so as to form a terminal of said second semiconductor region on the first surface.

2. The semiconductor structure as in claim 1 wherein the first and second semiconductor regions further comprise group III-V elements.

3. The semiconductor structure as in claim 2 wherein the first and second semiconductor regions further comprise a multi-junction solar cell.

4. The semiconductor structure as in claim 1 wherein the second surface further comprises a circular, square or rectangularly shaped charge collection electrode disposed on the second semiconductor region of the second surface

5. The semiconductor structure as in claim 4 wherein the circularly shaped charge collection electrode further comprises a plurality of radially extending members.

6. The semiconductor structure as in claim 5 wherein the charge collection electrode further forms an asterisk.

7. The semiconductor structure as in claim 1 further comprises a current collection grid on the first surface of the semiconductor surface.

8. The semiconductor structure as in claim 7 wherein the current collection grid further comprises a plurality of interdigitated conductive traces in which a first set of alternating traces are connected to the electrical connection and a second set of alternating traces are connected to the second semiconductor region.

9. A solar cell array comprising an upper, light illuminated surface and an opposing lower surface, said upper surface having a charge collecting element on the upper surface and an electrically conducting via extending between the upper and lower surfaces, said opposing lower surface having an electrical conductor extending over the lower surface of the array for making low resistance electrical contact with the charge collection element on the upper surface through the via and acting as charge accumulation path for the array.

10. The solar array as in claim 9 wherein the upper and lower surface further comprises group III-V elements.

11. The solar array as in claim 10 wherein the solar cell array further comprises a multi-junction solar cell array.

12. The solar array as in claim 9 wherein the charge collecting element further comprises a circular shape.

13. The solar array as in claim 12 wherein the circularly shaped charge collection element further comprises a plurality of radially extending members.

14. The semiconductor structure as in claim 13 wherein the charge collecting element further forms an asterisk.

15. The semiconductor structure as in claim 9 further comprising a plurality of charge collecting elements and vias.

16. The semiconductor structure as in claim 15 wherein the plurality of charge collecting elements and vias on the upper surface further comprise a plurality of electrical conductors on the lower surface that form a current collection grid.

17. The semiconductor structure as in claim 16 wherein the current collection grid further comprises a plurality of interdigitated conductive traces in which a first set of alternating traces are connected to the electrical conducting via and a second set of alternating traces form a second connection for the solar cell array.

18. A solar array comprising:
a first semiconductor region forming a first surface of a semiconductor structure of the solar array and having a first polarity;
a second semiconductor region forming a second surface of the semiconductor structure and having a second polarity;
at least one circularly-shaped charge collecting element disposed on the first semiconductor region;
an insulating via formed in the semiconductor structure from said first surface to said second surface;
an electrical connection extending through said via; and
an insulated contact pad on the second surface of the semiconductor structure, said electrical connection electrically connecting said at least one charge collecting element on the first semiconductor region and said insulated contact pad so as to form a terminal of said charge collecting element on the second surface.

19. The solar array as in claim 18 further comprising a plurality of circularly shaped charge collecting elements disposed on the first semiconductor region each having a respective insulating via and electrical connection extending through the via.

20. The solar array as in claim 19 further comprising a plurality of electrical conductors extending over the second surface of the array where at least a first electrical conductor of the plurality of conductors forms a connection among the charge collecting elements and at least a second conductor of the plurality of electrical conductors forms a second connection of the solar cell array.
